# EUROPEAN PATENT APPLICATION

(11) **EP 2 128 983 A1**
(43) Date of publication of application: **02.12.2009**
(21) Application number: 08156962.6
(22) Date of filing: 27.05.2008
(51) Int. Cl.: H03K 17/10, H03K 17/0814

(54) **High voltage drive circuit with improved power efficiency and reduced size**

(71) Applicant: Koninklijke Philips Electronics N.V., 5621 BA Eindhoven (NL)
(72) Inventor: The designation of the inventor has not yet been filed
(74) Representative: Damen, Daniel Martijn

(57) **Abstract**

A high voltage power supply circuit comprising:
- a control transistor (N1) having a control voltage input on a first gate electrode to switch the control transistor off when a first control voltage is applied to the first gate electrode and to switch the control transistor on when a second control voltage is applied to the first gate electrode,
- at least two cascoded transistors (N2, N3) coupled in series with the control transistor, and
- a biasing circuit (10) connected to second and third gate electrodes of the two cascoded transistors, respectively, the biasing circuit being adapted to switch the at least two cascoded transistors off when the first control voltage is applied to the first gate electrode and to switch the at least two cascoded transistors on when the second control voltage is applied to the first gate electrode, the steady state voltage drop across each of the at least two cascoded transistors being greater than the threshold voltage of each transistor when the first control voltage is applied to the first gate electrode.

## Description

### FIELD OF THE INVENTION

The present invention applies to methods and apparatus for high voltage applications, e.g. in LTPS TFT technology, or in particular in high voltage CMOS applications. In particular the present invention finds application as a high voltage power supply for heaters for rapid thermal cycling with improved power efficiency and reduced size in molecular diagnostics, e.g. in a PCR reactor for DNA amplification or for driving ink jet print heads.

### BACKGROUND OF THE INVENTION

Low Temperature Poly-Si (LTPS) technology, originally developed for active matrix displays, has reached a sufficient level of maturity that it is now being evaluated in a number of new non-display applications. LTPS enables CMOS circuits to be integrated directly onto glass or plastic substrates at a cost per unit area that is much lower than conventional CMOS IC processes in crystalline-silicon. The main technological limitation of LTPS is the relatively large minimum feature size (>1um) used in current LTPS production lines, which limits the number of transistors per unit area and hence the density of the circuitry that can be achieved. These properties make LTPS most attractive in applications that require circuits distributed over a large area at a relatively low density. Recent non-display applications being evaluated include: (i) LTPS bio-electronics for molecular diagnostics applications (ii) LTPS drivers for piezo-electric and thermal ink-jet print heads, and (iii) LTPS for driving inorganic LED arrays for lighting and signage applications.

In all CMOS processes (LTPS and crystalline Si) there is a limit to the maximum voltage that can be applied between the source and drain (VDSmax) and also the maximum voltage that can be applied between the gate and source (VGSmax). Above these maximum voltages the CMOS transistors become unstable and degrade over time, leading to premature failure of the device. In situations where circuits must be operated at voltages greater than VDSmax and VGSmax two approaches are possible: (i) modifications can be made to the process technology or transistor structure to engineer the fabrication of both low and high voltage devices by, for example, including dual thickness gate dielectrics, or (ii) implementation of circuit solutions that use multiple low voltage transistors in an arrangement such that the voltage across any one transistor is below the maximum. The advantage of the second (circuit) approach is that no changes to the technology or device structure are required.

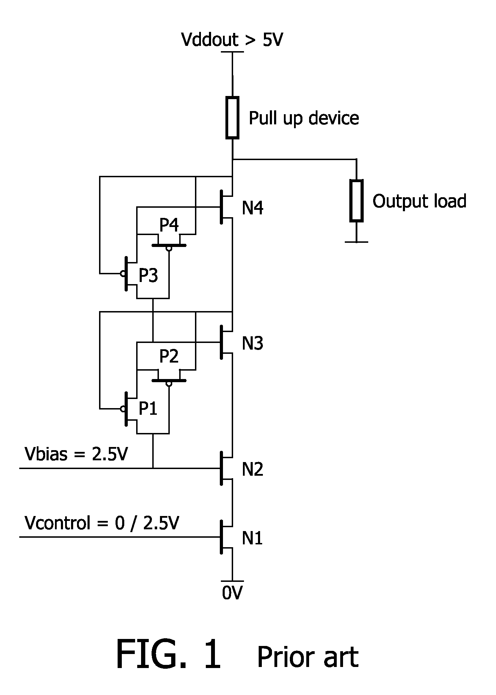

A cascode circuit has been published in 2001 in IEEE Journal of Solid State Circuits, vo136, no3, p528 (by Annema, Geelen and Jong) in which additional transistors are added to a basic cascode circuit to increase the maximum operating voltage above 2Vdd. An example of this circuit is shown in Figure 1, for a 2.5V CMOS process. There are three cascode transistors, N2, N3 and N4. PMOS transistors P1 and P2 are used to set the gate bias of N3. Similarly, P3 and P4 set the gate bias of N4. At least theoretically, any number of cascode transitors could be stacked on top of each other. When the control voltage applied to the gate of N1 is high (2.5V), the output voltage is pulled down to 0V. The gates of PMOS transistors P1 and P3 are also at 0V so they are turned on, while P2 and P4 are turned off. This sets the gate voltage of N3 and N4 at 2.5V as required and the source drain voltages of N1-N4 are close to 0V. When the control voltage is switched to 0V the output is pulled up to a higher voltage, which causes P3 to turn off and P4 to turn on. This connects the gate of N4 its drain (=output node), which means N4 remains conducting until the voltage between the source and drain is equal to Vt (Vt=NMOS transistor threshold voltage). When the gate and drain of an NMOS transistor are connected in this way it is often described as being "diode connected" with a switch on voltage of Vt. As the voltage at the drain of N3 is pulled high, it too becomes diode connected because P2 turns on. N3 remains conducting until the voltage at the source increases and the voltage between the source and drain is equal to Vt. This means that with Vcontrol=0, there is a voltage drop of approximately the threshold voltage Vt across N3 and Vt across N4, with the remaining voltage (Vddout - 2Vt) dropped across N2 and N1.

The circuit of Figure 1 works well in relatively low voltage CMOS processes where the threshold voltages of the CMOS transistors are comparable to the maximum operating voltage of the devices. For example in a standard CMOS process with a maximum operating voltage of 2.5V the threshold voltage of the transistors is likely to be between 0.5 and 1V, so the diode connected NMOS transistors N3 and N4 drop a significant voltage when Vcontrol =0. However, this is not the case in several high voltage applications of poly-Si TFTs, in which the maximum operating voltage is approximately 20V compared with a threshold voltage of approximately 2-3V. In various applications of LTPS much higher voltages are required, e.g. in molecular diagnostics, in the case of a PCR array controlled by poly-Si TFTs, it is desirable to drive the heating resistors from a power supply voltage of at least 60V, which is 3 times the maximum operating voltage and many more times the TFT threshold voltage. Very similar voltages are also required in ink jet printing applications of LTPS. For this reason the approach shown in Fig. 1 is not efficient for high voltage poly-Si TFT applications because it relies on diode connected transistors (when Vcontrol=0) each dropping approximately one threshold voltage.

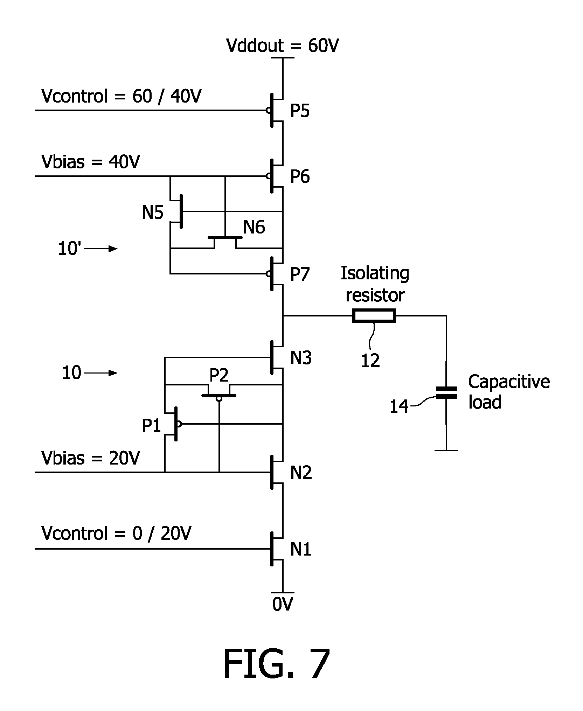

Known circuits in US6,320,414B1 act to switch a voltage VH that is greater than the control voltage VL by dividing the larger voltage (VH) amongst the VDS of several transistors. Essentially the protection is given to the transistors by ensuring that the drain-source voltages in the high output voltage state are shared by these transistors such that for no transistor does the drain-source voltage exceed a damage threshold. To facilitate this, T4 in Fig 7 is diode-connected. The diode-connected transistor, "T4" provides a voltage drop of V_{threshold} (Vt) across the drive transistor. This connection ensures that the threshold voltage of the transistor T4 is dropped across its drain-source when Vds > Vthreshold. In so doing, each time such a diode-connected pair is added to the cascode output stage, the maximum switched output voltage Vh is increased by a voltage equal to the threshold voltage. This connection works in situations where the goal is to switch relatively small voltages VH, e.g. of ∼5V, but would not work efficiently for higher voltages. Implemented in polysilicon, each additional T4 device in the cascode increases the switched voltage VH by only -3V. To switch a voltage of 75V would therefore require a large number of such cascoded devices. Additionally, every time a diode-connected device is added to the cascode, all devices in the cascode must be made with a wider channel width in order to switch the same current as before. The net result is that such a connection in polysilicon is impractical owing to the width of the devices (and hence polysilicon area and cost consumed) that would be demanded by any application in which a significant current is switched into the load.

### SUMMARY OF THE INVENTION

An object of the present invention is to provide methods and apparatus for high voltage applications, e.g. in LTPS TFT technology, or in particular high voltage CMOS applications. An advantage of the present invention is the provision of a high voltage power supply for heaters for rapid thermal cycling with improved power efficiency and reduced size in molecular diagnostics, e.g. in a PCR reactor for DNA amplification or for driving ink jet print heads.

The present invention provides a high voltage power supply circuit comprising:
- a control transistor having a control voltage input on a first gate electrode to switch the control transistor off when a first control voltage is applied to the first gate electrode and to switch the control transistor on when a second control voltage is applied to the first gate electrode,
- at least two cascoded transistors coupled in series with the control transistor, and
- a biasing circuit connected to second and third gate electrodes of the two cascoded transistors, respectively, the biasing circuit being adapted to switch the at least two cascoded transistors off when the first control voltage is applied to the first gate electrode and to switch the at least two cascoded transistors on when the second control voltage is applied to the first gate electrode, the steady state voltage drop across each of the at least two cascoded transistors being greater than the threshold voltage of each transistor when the first control voltage is applied to the first gate electrode.

An advantage of this circuit is that the voltage dropped across each cascode transistor is large so that voltages in excess of 60 volts can be provided with a reasonably practical number of cascode stages. For example, the steady state voltage drop across each of the at least two cascoded transistors is greater than five times the threshold voltage of each transistor.

Preferably the biasing circuit shorts the gate to source voltage of each cascode transistor to drive each cascode transistor off when the first control voltage is applied to the first gate electrode. This avoids the need to have these transistor diode connected when the first control voltage is applied which reduces the voltage dropped across these transistors to only the threshold voltage.

The cascode transistors can have a first conductivity, e.g. they are NMOS transistors, and the biasing circuit has two transistors of a second conductivity, e.g. PMOS transistors. This has the advantage that CMOS processing can be used, in particular LTPS CMOS processing can be used to manufacture the supply circuit.

In a preferred embodiment, the biasing circuit has a first and a second transistor, the sources of the first and a second transistors being connected to the gate of one of the at least two cascode transistors, the gate of the second transistor being connected to the drain of the first transistor and the gate of another of the at least two cascode transistors, the gate of the first transistor being connected to the source of the one of the at least two cascode transistors and also to the gate of the second transistor.

This arrangement provides a compact biasing circuit with few components that is suitable for CMOS processing.

A third transistor can be coupled between the at least two cascode transistors and an output of the high voltage power supply circuit, the third transistor being diode connected to function as an isolating resistor when the control voltage is being switched from low to high.

This has the advantage that voltage peaks that can be generated when changing the control voltage from low to high can be reduced hence reducing or eliminating the risk of overvoltage damage.

To provide additional protection against overvoltages, a resistor network having a plurality of resistors in series separated by first nodes can be provided, some of the first nodes being connected to second nodes between the at least two cascode transistors and/or between the control transistor and the at least two cascode transistors.

The resistor network provides additional control of the voltages between the transistors in the cascode arrangement and hence helps to guarantee the same voltage drop across each of these transistors, which also helps to prevent overvoltage spikes.

In accordance with all the embodiments of the present invention, any of the transistors can be thin film transistors. This allows a very economic manufacture of the supply circuit. In particular, the transistors can be LTPS transistors, e.g. allowing a 20 volt drop across each of the transistors of the cascode arrangement.

The present invention in another aspect provides a high voltage power supply circuit having a pull-up cascode arrangement comprising a first control transistor having a control voltage input on a first gate electrode to switch the first control transistor off when a first control voltage is applied to the first gate electrode and to switch the first control transistor on when a second control voltage is applied to the first gate electrode,
- at least first and second cascoded transistors coupled in series with the first control transistor, and
- a first biasing circuit connected to second and third gate electrodes of the at least first and second cascoded transistors, respectively, the first biasing circuit being adapted to switch the at least first and second cascoded transistors off when the first control voltage is applied to the first gate electrode and to switch the at least first and seecond cascoded transistors on when the second control voltage is applied to the first gate electrode, the steady state voltage drop across each of the at least first and second cascoded transistors being greater than the threshold voltage of each transistor when the first control voltage is applied to the first gate electrode; and
- a pull-down cascode arrangement comprising a second control transistor having a control voltage input on a second gate electrode to switch the second control transistor off when a third control voltage is applied to the second gate electrode and to switch the second control transistor on when a fourth control voltage is applied to the first gate electrode,
- at least third and fouth cascoded transistors coupled in series with the second control transistor, and
- a second biasing circuit connected to third and fourth gate electrodes of the third and fourth cascoded transistors, respectively, the second biasing circuit being adapted to switch the at least third and fouth cascoded transistors off when the third control voltage is applied to the second gate electrode and to switch the at least third and fourth cascoded transistors on when the fourth control voltage is applied to the second gate electrode, the steady state voltage drop across each of the at least thrid and fourth cascoded transistors being greater than the threshold voltage of each transistor when the third control voltage is applied to the first gate electrode.

This combination of pull-up and pull-down cascode circuits is advantageous when the load is capacitive, e.g. when driving an inkjet print head.

In another aspect the present invention provides, a method of operating a high voltage power supply circuit comprising:
- a control transistor having a control voltage input on a first gate electrode to switch the control transistor off when a first control voltage is applied to the first gate electrode and to switch the control transistor on when a second control voltage is applied to the first gate electrode,
- at least two cascoded transistors coupled in series with the control transistor, and
   the method comprising:
- switching the at least two cascoded transistors off when the first control voltage is applied to the first gate electrode and switching the at least two cascoded transistors on when the second control voltage is applied to the first gate electrode, the steady state voltage drop across each of the at least two cascoded transistors being greater than the threshold voltage of each transistor when the first control voltage is applied to the first gate electrode.

The steady state voltage dropped across each of the at least two cascoded transistors can greater than five times the threshold voltage of each transistor, e.g. it can be 20 volts.

To avoid the use of diode connected transistors, the gate to source voltage of each cascode transistor is preferably shorted to drive each cascode transistor off when the the first control voltage is applied to the first gate electrode.

The present invention find advantageous use to drive heaters in a PCR reactor or an inkjet print head.

The present invention will now be described with reference to the following drawings which are schematic.

### BRIEF DESCRIPTION OF THE DRAWINGS

Fig. 1 shows a prior art supply circuit.
Fig. 2 shows a supply circuit in accordance with an embodiment of the present invention.
Fig. 3 shows a supply circuit in accordance with an embodiment of the present invention having a bias circuit.
Fig. 4 shows a supply circuit in accordance with another embodiment of the present invention having an additional cascode stage.
Fig. 5 shows a supply circuit in accordance with another embodiment of the present invention having an isolating resistor at the output.
Fig. 6 shows a supply circuit in accordance with another embodiment of the present invention having an additional diode connection stage as an isolating resistor.
Fig. 7 shows a supply circuit in accordance with another embodiment of the present invention having pull-down and pull-up cascode arrangements.
Fig. 8 is a figure showing a capacitance divider of the circuit of Fig. 3
Fig. 9 shows a resistor network for us with the present invention.
Fig. 10 shows a supply circuit in accordance with another embodiment of the present invention having a resistor network to control inter-transistor voltages.

### DETAILED DESCRIPTION OF THE ILLUSTRATIVE EMBODIMENTS

Although the present invention will be described in connection with certain embodiments, it is not intended to be limited to the specific form set forth herein. Rather, the scope of the present invention is limited only by the accompanying claims. In the claims, the term "comprising" does not exclude the presence of other elements or steps. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Furthermore, reference signs in the claims shall not be construed as limiting the scope.

Low Temperature Poly-Si (LTPS) technology was originally developed for active matrix displays. LTPS enables CMOS circuits to be integrated directly onto insulating substrates such as glass or plastic substrates at a cost per unit area that is much lower than conventional CMOS IC processes in crystalline-Si. The present invention expands the use of a high output voltage drive circuit to achieve higher voltages such as 60-100v or higher with for example resistive heaters without causing permanent voltage stressing to the transistors.

Applications of the present invention include (i) LTPS bio-electronics for molecular diagnostics applications (ii) LTPS drivers for piezo-electric and thermal ink-jet print heads, and (iii) LTPS for driving inorganic LED arrays for lighting and signage applications. For example, the present invention provides a high voltage power supply for Lab-On-A-Chip (LOAC) functions, for example PCR, that require the generation and control of high temperatures to provide thermal cycling from 50°C up to 100°C. This requires high power dissipation in localised areas and can be practically achieved in accordance with the present invention by a power supply operating at voltages of 60-100 volts or higher, e.g. in LTPS. The present invention provides a temperature processing array for DNA amplification using the polymerise chain reaction (PCR). The present invention may be implemented in a disposable integrated cartridge with micro-fluidics, sensing and optionally other functions controlled by LTPS circuits on a substrate such as glass.

Accurate temperature control and temperature cycling is critical to the PCR process and is achieved in accordance with an aspect of the present invention by using LTPS TFTs to control the power supplied to a number of integrated heaters such as resistive heaters. The present invention may also be applied to several other bio-medical devices and processes, e.g. requiring the use of resistive heaters such as thermo-pneumatic pumps/values, flow rate sensing and blood gas analysis.

In order to reach temperatures in the range of 50°C-100°C suitable for PCR, the heaters must dissipate a certain power density that depends on the thickness of the substrate and if there is any insulation to an external heat sink. Preferably a highly insulating substrate for low power is used. A fast PCR cycler operates 10min for 30 cycles, e.g. for point of care (POC) applications. This requires power densities in the range of 0.12 W/mm². If a temperature guard ring is used to ensure temperature uniformity, this would require even higher power densities of around 0.17W/mm². With adequate fluid volumes of 25uL over a surface area of 100mm² a total power of about 12W is required. The majority of this power is dissipated through the substrate.

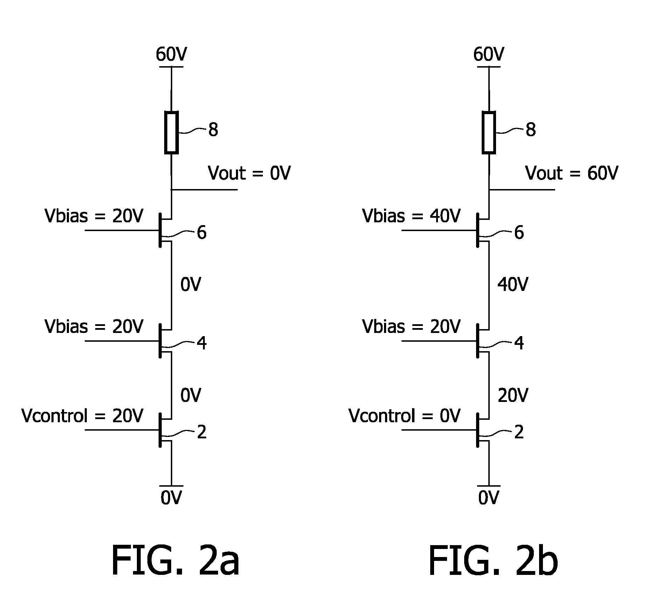

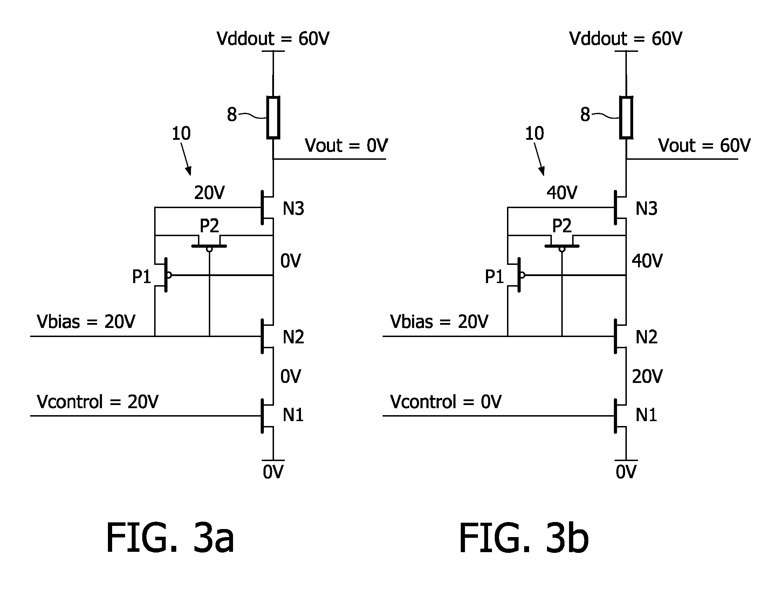

An embodiment suitable for LPTS will now be described with reference to Figs. 2 and 3. Referring to Fig. 2 a cascode arrangement of TFT's 2, 4, 6 is shown having a pull-up device 8. In the following the first transistor 2 that receives an input control signal Vcontrol will be described as the control transistor or switch. The two transistors N2 and N3 (or more) connected in series with the control transistor N1 will be called the cascoded transistors. In the case of 20V TFTs (Thin Film Transistors) and the requirement of a 60V power supply, a minimum of 3 TFTs 2, 4, 6 are required to support the 60V voltage drop when Vcontrol = 0V. However because the voltage between the gate-source and gate-drain must also be maintained at approximately 20V or less, it is necessary to use different gate voltages for Vcontrol = high (20V) and Vcontrol = low (0V). Optimum voltages are shown in Figure 2. In Figure 2 the maximum source-drain, gate-source and gate-drain voltages are always maintained within the safe operating limit of 20V.

In Figure 2(a) the TFTs 2, 4, 6 are turned on and the gate voltages are all at 20V. In Figure 2(b), the TFTs 2, 4, 6 are turned off and the gate voltages increase up the cascode circuit from 0 to 20 and then to 40V. In Figure 2 when Vcontrol=0V none of the TFTs 2, 4, 6 in Figure 2(b) are operating in a diode connected mode. The specific voltages shown in Figure 2 and mentioned with respect to other embodiments are for example only and it is clear that the same concept is applicable for transistors with a different maximum operating voltage and different output voltage swing.

In accordance with an embodiment of the present invention the optimum TFT voltages shown in Figure 2 can be achieved using the circuit shown in figure 3. This example refers to the case of 20V NMOS TFTs N1, N2, N3 switching the output voltage through 60V, but this embodiment can be generalised to other voltages.

The cascode circuit of Fig. 3 has a control transistor N1 and two cascoded transistors N2 and N3. A biasing circuit 10 is provided by PMOS transistors P1 and P2. The sources of P1 and P2 connect to the gate of N3, the gate of P2 connects to the drain of P1 and the gate of N2, the gate of P1 connects to the source of N3. In particular the biasing circuit 10 is connected to the gates of two of the cascode transistors N2, N3. The cascode transistors have a first conductivity type, e.g. are NMOS transistors, and the transistors of the biasing circuit have a second conductivity type, e.g. are PMOS transistors. Although the cascode transistors N2 and N3 are shown as individual transistors, they may be replaced by transistor circuits having a similar behaviour as a single transistor. Although the transistors P1 and P2 of the biasing circuit 10 are shown as individual transistors, they may be replaced by transistor circuits having a similar behaviour as a single transistor.

Figure 3(a) shows the voltages in the circuit when the input control voltage Vcontrol is high (20V), in which case transistor P1 is turned on and transistor P2 is turned off. This means that transistors N1-N3 all have a gate voltage of 20V and the output voltage is pulled down to ground (0V) as are the nodes between N1-N2 and N2-N3. Figure 3(b) shows the voltages in the circuit after the input control voltage is switched low (0V), in which case transistor N1 turns off and the output voltage is pulled high. In turn the node between N2 and N3 is pulled high, which causes transistor P1 to turn off and transistor P2 to turn on. In particular, in the steady state high configuration the top TFT (N3) of the cascode arrangement is switched off by shorting its gate to source voltage Vgs through P2, enabling a drain voltage drop of close to the damage voltage of 25V. From symmetry the steady state voltage between N2 and N3 will settle at 40V and the steady state voltage between N2 and N1 will settle at 20V, in which case the leakage currents through N1-N3 are all equal. In Figure 3(b) when the input control voltage Vcontrol is low (=0V) none of the TFTs N1, N2, N3 are diode connected. This means that for each cascoded transistor of Fig. 3(b) that is added to the cascode output stage, the maximum switched output voltage Vh is increased by a voltage greater than the threshold voltage of that transistor (about 1V in Silicon, about 3V in polysilicon) and ideally much greater, e.g. at least 5 times the threshold voltage, or more such as 20V. In circuits of the present invention each additional transistor device in the cascode increases the capability of the switched voltage by a voltage equal to the damage threshold voltage of the devices, e.g. 25V for polysilicon, or somewhat below, e.g. 20% below at 20V, or alternatively 10% below or 25% below, for example. Additionally, whereas every time a diode-connected device is added to the cascode, all devices in the cascode must be made with a wider channel width in order to switch the same current as before, this is not required for the present invention.

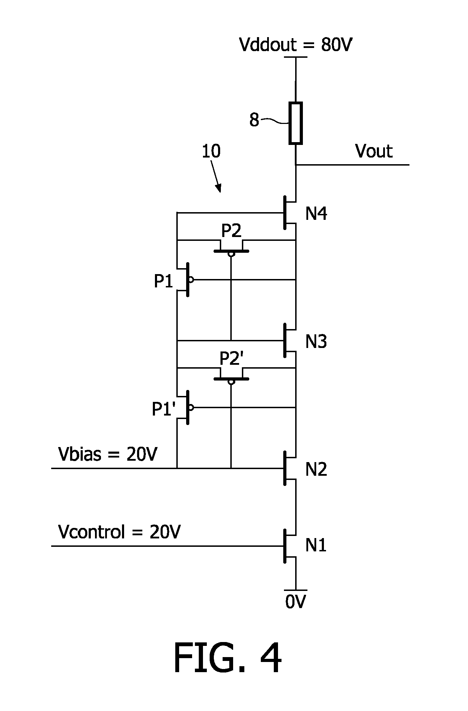

In figure 3 there are 2 cascode transistors, N2 and N3, but the same concept can easily be extended to any number of additional cascode stages. Figure 4, shows how 3 cascode stages would be configured to enable the output voltage swing to be increased to 80V, but based on the same principle as in figure 3. In the circuit of Fig. 4 there are four transistors N1-N4 with a control transistor N1 and transistors N2 to N4 making up the cascode arrangement as well as a pull-up device 8. The transistors N1 to N4 are all of the same conductivity type, e.g. NMOS. The gates of at least two of the cascode transistors N2, N3, N4 are connected to the biasing circuit 10. In this embodiment the biasing circuit 10 is in fact connected to the gates of three of the cascode transistors N2, N3. N4. When the input control voltage Vcontrol is high (20V), transistors P1, P1' are turned on and transistors P2, P2' are turned off. This means that transistors N1-N4 all have a gate voltage of 20V and the output voltage is pulled down to ground (0V) as are the nodes between N1-N2 and N2-N3 and N3 and N4. After the input control voltage is switched low (0V), the control transistor N1 turns off and the output voltage is pulled high. In turn the node between N2 and N3 is pulled high, which causes transistor P1' to turn off and transistor P2' to turn on. In turn the node between N3 and N4 is pulled high which causes transistor P1 to turn off and transistor P2 to turn on. From symmetry the steady state voltage between N4 and N3 will settle at 60V, the node between N2 and N3 will settle at 40V and the steady state voltage between N2 and N1 will settle at 20V, in which case the leakage currents through N1-N4 are all equal. When the input control voltage Vcontrol is low (=0V) none of the TFTs N1, N2, N3, N4 are diode connected. This means that for each cascoded transistor that is added to the cascode output stage, e.g. N4 in this case, the maximum switched output voltage Vh is increased by a voltage greater than the threshold voltage of that transistor (about 1V in Silicon, about 3V in polysilicon) and ideally much greater, e.g. at least 5 times,
for example 20V. In circuits of the present invention each additional transistor device in the cascode, e.g. N4 increases the capability of the switched voltage by a voltage equal to the damage threshold voltage of the devices, e.g. 25V for polysilicon, or somewhat below, e.g. 20% below at 20V, or alternatively 10% below or 25% below, for example. Additionally, whereas every time a diode-connected device is added to the cascode, all devices in the cascode must be made with a wider channel width in order to switch the same current as before, this is not required for the present invention.

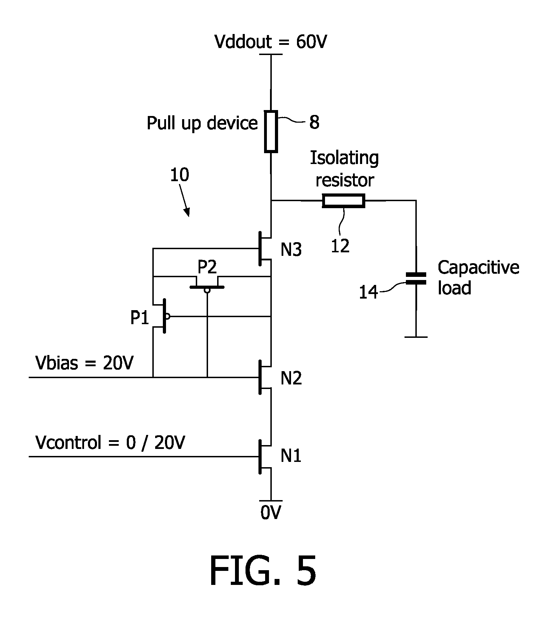

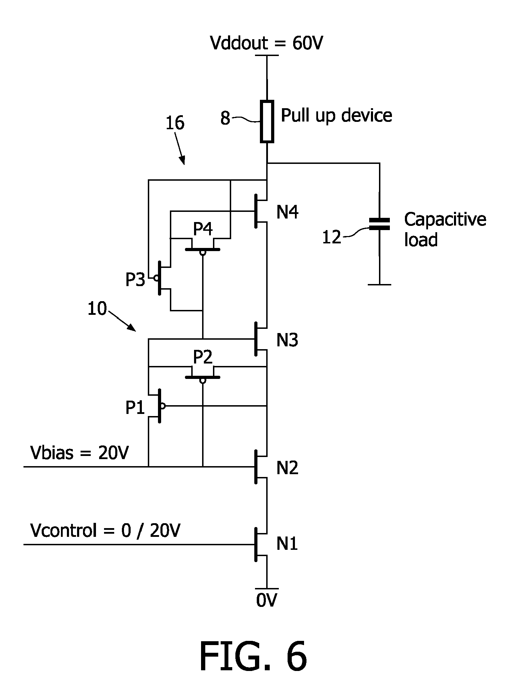

One possible issue with the circuit in figure 3 occurs when the input control voltage Vcontrol switches from a low value (0V) to high value (20V) and there is also a significant capacitive load on the output (e.g. in the case of a piezo-electric ink jet head where the load is predominantly capacitive). In this case the voltage between N1 and N2 and between N2 and N3 drops quickly, but the output voltage drops much more slowly due to the charge stored on the output capacitance. This can result in a short voltage spike across the source and drain of N3 in excess of the maximum 20V. A simple way to circumvent this problem is to add an isolating resistor 12 between the output of the cascode drive circuit and the load 14, as shown in figure 5. This can be used to minimise the size and duration of the voltage spike. An alternative approach that achieves a similar effect is to add an extra cascode stage which is diode connected when the input control voltage is low, i.e. it emulates a resistor. An example is shown in figure 6 in which N4 is diode connected when the input control voltage is low - all other transistors are not diode connected. A first biasing circuit 10 as previously described with respect to the present invention is connected to the gates of cascode transistors N2 and N3. A second biasing circuit 16 of the prior art is connected to the gates of the transistors N3 and N4. The second biasing circuit 16 has two transistors P3 and P4 of a different conductivity type (e.g. PMOS) as the transistors N1-N4 of the cascode arrangement. In the circuit of Fig. 6, when Vcontrol is high, the gate of PMOS transistor P3 is at 0V so it is turned on, while P4 is turned off. The source drain voltages of N1-N4 are close to 0V. When the control voltage is switched to 0V the output is pulled up to a higher voltage, which causes P3 to turn off and P4 to turn on. This connects the gate of N4 to its drain (=output node), which means N4 remains conducting until the voltage between the source and drain is equal to Vt (Vt=NMOS transistor threshold voltage). When the gate and drain of an NMOS transistor are connected in this way it is described as being "diode connected" with a switch on voltage of Vt. This means that with Vcontrol=0, there is a voltage drop of approximately 20V across N3 and Vt across N4, with the remaining voltage (Vddout - 20 - Vt) dropped across N2 and N1. When the control signal is switched from low (0V) to high (20V), N4 is initially diode connected so it behaves as an isolating resistor between N3 and the output capacitance, then after a certain time a steady state is reached (with Vcontrol=high) and the gate of N4 is at 20V and all internal nodes between N1-N4 are at 0V. Hence in accordance with some embodiments of the present invention some of the additional transistor devices in the cascode increase the capability of the switched voltage by a voltage equal to the damage threshold voltage of the devices, e.g. 25V for polysilicon, or somewhat below, e.g. 20% below at 20V. At least one final transistor can be diode connected as an isolating resistor between the last transistor of the cascode and the load when the input control voltage is being switched from low to high.
In the embodiments referred to above NMOS cascoded devices are used to switch the output voltage from high to low as well as a PMOS biasing circuit. However, the present invention includes that the equivalent complementary circuit can be constructed using PMOS devices to switch the output from a low value to a high value and NMOS biasing circuits. For example, by taking the top half of Fig. 7 and replacing N1, N2 and N3 with a resistor a PMOS cascode circuit is obtained that works in a similar fashion to the NMOS cascode.

Figure 7 shows an example where active devices are used for driving a capacitive load 14 from both low to high (PMOS cascode) and high to low (NMOS cascode). This circuit can be used to drive a piezo-electric inkjet print head, for example. The PMOS cascode is the PMOS version of the circuit of Fig. 3 and comprises 3 or more PMOS transistors P1 to P3 and a biasing circuit 10' with NMOS transistors N5 and N6 providing the same function as previously described for the biasing circuit 10 but for the PMOS cascode. The NMOS cascode comprises the same components as in Fig. 3. In order to avoid prohibitive levels of power dissipation in the off state at the output stage, the CMOS-type switch of Fig. 7 comprises both pull-up (NMOS cascode) and pull-down (PMOS cascode) devices. This is preferred when load is capacitive as opposed to resistive. In applications which require a CMOS-type output stage the circuit of Fig. 7 gives a full and practical implementation for generating the necessary voltages for switching the devices in a level shifter.

A high voltage power supply has been described above for voltages of up to 100v or beyond. The LTPS devices have a means to ensure they do not receive voltages in excess of their degradation breakdown voltage, (high electric fields), e.g. are limited to a value below the degradation voltage, e.g. 10, 20 or 25% below the degradation voltage. When used with an NMOS cascode, a PMOS biasing circuit is used, the PMOS biasing circuit preferably being tuned to ensure voltages do not reach in excess of the 25v LTPS breakdown voltages on the Gate-Source, drain-source TFT terminals. When the switching from the on to off state, there are a series of transient effects on each node taking place. Caused by gate-source and gate-drain overlapping layers, these TFT capacitances are preferably be tuned by sizing the PMOS biasing network. The purpose is to achieve that the internal drive transistor nodes approach an equal voltage division.

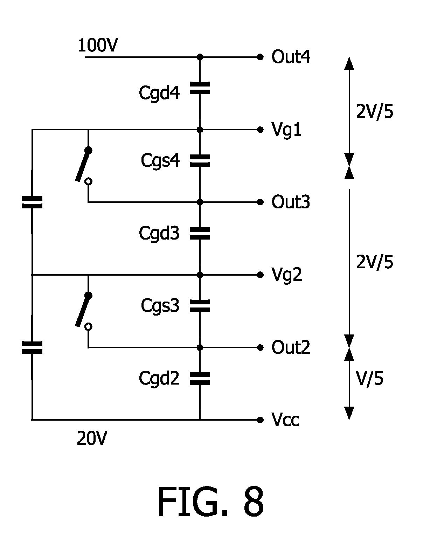

When driving a resistive load for heater applications there is the absence of any large load capacitances in the circuit, making the circuit respond rapidly, e.g. in about 100ns. This means stacking on extra cascode stages to reach a higher voltage can cause the steady state voltages across each cascode transistor to be determined by the parasitic capacitances in the circuit. These cannot be reliably controlled in a fabrication process. This can make power supplies above 60v hard to achieve. The off-state of the circuit of figure 4 described above can be represented by a complex capacitor network as shown in figure 8 where each capacitor value is determined by the alignment tolerances of the source-gate-drain overlaps. The voltage across each drive TFT begins to increase, and after a short time, e.g. 5 microseconds the voltages across each capacitor have settled, fully charged but not necessarily with equal voltages across each. Hence there is a danger that the voltage across one capacitor is above the 25 volt limit. Making each of the capacitors settle with 25v or less across each increases in difficulty as the number of cascode transistors increases. Such a circuit could be very prone to processing variations, showing that one drive transistor can easily end up with more than 25v across the source-drain. The end result is damage and rapid failure, e.g. during the PCR cycling.

Experimental measurements of LTPS transistors have been made under a series of pulsed conditions to establish the failure point of a typical LTPS device, either from the duration of the applied drain-source voltage or the maximum drain-source voltage. Under high duty ratio, DC conditions, the gate at near threshold, and high source-drain bias (>10v), the LTPS TFTs can be unstable. The LTPS TFTs can suffer significant hot carrier stressing and charge injection into the gate-oxide, causing rapid failure. However the devices remain relatively stable for low duty pulses of less than 100 microseconds, e.g. for 10,000s of repeats, while also surviving maximum voltages in excess of 50v if designed with long device lengths, and Gate Overlapped Lightly Doped Drains (GOLDD) with the same implant in the Source region as well.

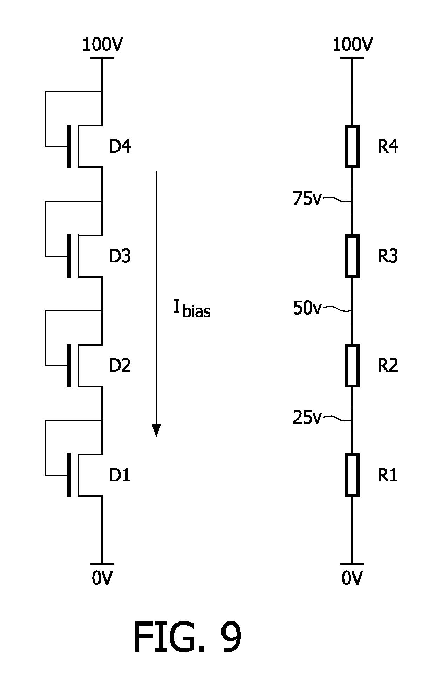

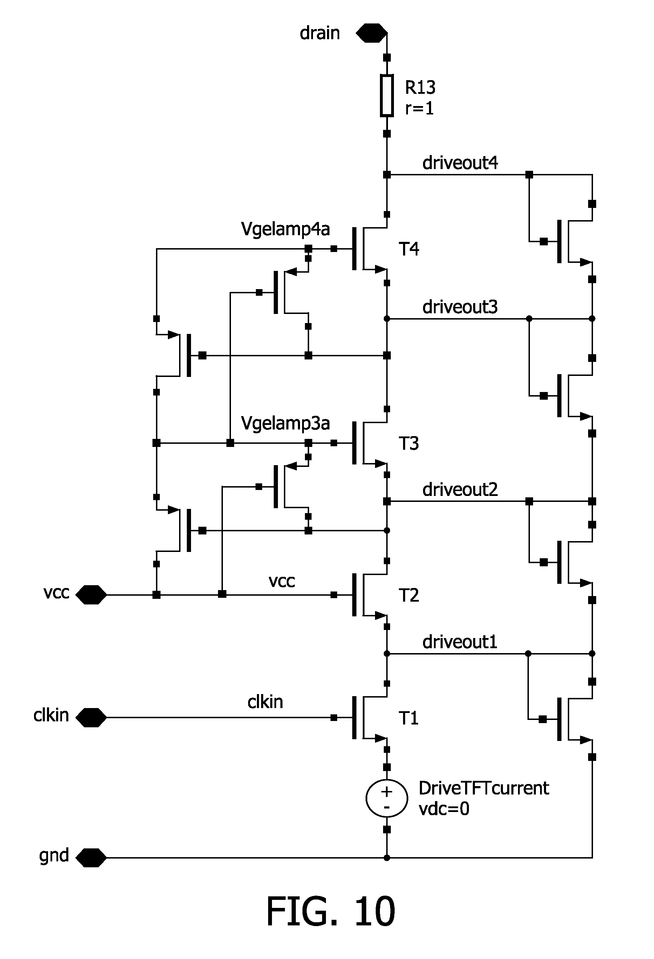

Figure 9 shows a series of diode connected TFTs or alternatively resistors of a high resistance. In their steady state, the voltages across each device will be 25v, behaving like a resistive divider. By connecting the resistor network in parallel with the cascode arrangement of the present invention (see Fig. 10) one or more resistors is placed across each drive TFT of the cascode arrangement. The drive circuit can now ensure that any transient voltages in excess of 25v (or the powersupply/4) are removed quickly (-10 microseconds). There will always be the finite period of time where the voltages are left over their desired maximum, but from the pulsed measurements it has been established that this maximum can be both large, e.g. about 50v and up to 100 microseconds in duration before damage occurs.

In the circuit of Fig. 10, four (or more if resired) diode connected TFTs pass current from the high voltage terminal to ground and are each connected to an internal node between drive transistors of the cascode arrangement. They are preferably sized to be long L devices (>5um up to 50um), reducing the electric field across the TFT. A minimum of four diode connected transistors are typically required to make the necessary node connections, but more than 1 diode connected transistor can be connected between each drive transistor. For example 2 diode connected TFTs can be placed between each drive transistor of the cascode arrangement, keeping the maximum gate-source voltage at 12.5v and ensuring safe operation.

Finally because the diode connected transistors have very long L dimensions, this also suits the overall circuits objective by acting to stabilise the DC voltages without contributing large bias currents to ground. Micro-amps of current are sufficient to resolve the DC operating conditions quickly, e.g. below <100 microseconds.

By making use of this improvement in the off-state voltages across each of the drive transistor of the cascode arrangement, an M stage Drive TFT circuit can be realised, where M is 4 or greater allowing safe usage of a power supply voltage from 80v-100v or higher, and giving substantial improvement in power efficiency plus a reduction in size of the drive transistors and their associated power track widths.

## Claims

1. A high voltage power supply circuit comprising:
- a control transistor having a control voltage input on a first gate electrode to switch the control transistor off when a first control voltage is applied to the first gate electrode and to switch the control transistor on when a second control voltage is applied to the first gate electrode,
- at least two cascoded transistors coupled in series with the control transistor, and
- a biasing circuit connected to second and third gate electrodes of the two cascoded transistors, respectively, the biasing circuit being adapted to switch the at least two cascoded transistors off when the first control voltage is applied to the first gate electrode and to switch the at least two cascoded transistors on when the second control voltage is applied to the first gate electrode, the steady state voltage drop across each of the at least two cascoded transistors being greater than the threshold voltage of each transistor when the first control voltage is applied to the first gate electrode.

2. The high voltage power supply circuit according to claim 1, wherein the steady state voltage drop across each of the at least two cascoded transistors is greater than five times the threshold voltage of each transistor.

3. The high voltage power supply circuit according to claim 1 or 2, wherein the biasing circuit shorts the gate to source voltage of each cascode transistor to drive each cascode transistor off when the first control voltage is applied to the first gate electrode.

4. The high voltage power supply circuit according to any previous claim, wherein the cascode transistors have a first conductivity and the biasing circuit has two transistors of a second conductivity.

5. The high voltage power supply circuit of claim 4, wherein the biasing circuit has a first and a second transistor, the sources of the first and a second transistors being connected to the gate of one of the at least two cascode transistors, the gate of the second transistor being connected to the drain of the first transistor and the gate of another of the at least two cascode transistors, the gate of the first transistor being connected to the source of the one of the at least two cascode transistors and also to the gate of the second transistor.

6. The high voltage power supply circuit of any previous claim further comprising a third transistor coupled between the at least two cascode transistors and an output of the high voltage power supply circuit, the third transistor being diode connected to function as an isolating resistor when the control voltage is being switched from low to high.

7. The high voltage power supply circuit of any previous claim further comprising a resistor network having a plurality of resistors in series separated by first nodes, some of the first nodes being connected to second nodes between the at least two cascode transistors and/or between the control transistor and the at least two cascode transistors.

8. The high voltage power supply circuit of any previous claim wherein any of the transistors are thin film transistors.

9. The high voltage power supply circuit of any previous claim wherein the transistors are LTPS transistors.

10. A high voltage power supply circuit having a pull-up cascode arrangement comprising a first control transistor having a control voltage input on a first gate electrode to switch the first control transistor off when a first control voltage is applied to the first gate electrode and to switch the first control transistor on when a second control voltage is applied to the first gate electrode,
- at least first and second cascoded transistors coupled in series with the first control transistor, and
- a first biasing circuit connected to second and third gate electrodes of the at least first and second cascoded transistors, respectively, the first biasing circuit being adapted to switch the at least first and second cascoded transistors off when the first control voltage is applied to the first gate electrode and to switch the at least first and seecond cascoded transistors on when the second control voltage is applied to the first gate electrode, the steady state voltage drop across each of the at least first and second cascoded transistors being greater than the threshold voltage of each transistor when the first control voltage is applied to the first gate electrode; and
- a pull-down cascode arrangement comprising a second control transistor having a control voltage input on a second gate electrode to switch the second control transistor off when a third control voltage is applied to the second gate electrode and to switch the second control transistor on when a fourth control voltage is applied to the first gate electrode,
- at least third and fouth cascoded transistors coupled in series with the second control transistor, and
- a second biasing circuit connected to third and fourth gate electrodes of the third and fourth cascoded transistors, respectively, the second biasing circuit being adapted to switch the at least third and fouth cascoded transistors off when the third control voltage is applied to the second gate electrode and to switch the at least third and fourth cascoded transistors on when the fourth control voltage is applied to the second gate electrode, the steady state voltage drop across each of the at least thrid and fourth cascoded transistors being greater than the threshold voltage of each transistor when the third control voltage is applied to the first gate electrode.

11. A method of operating a high voltage power supply circuit comprising:
- a control transistor having a control voltage input on a first gate electrode to switch the control transistor off when a first control voltage is applied to the first gate electrode and to switch the control transistor on when a second control voltage is applied to the first gate electrode,
- at least two cascoded transistors coupled in series with the control transistor, and
the method comprising:
- switching the at least two cascoded transistors off when the first control voltage is applied to the first gate electrode and switching the at least two cascoded transistors on when the second control voltage is applied to the first gate electrode, the steady state voltage drop across each of the at least two cascoded transistors being greater than the threshold voltage of each transistor when the first control voltage is applied to the first gate electrode.

12. The method of claim 11, wherein the steady state voltage drop across each of the at least two cascoded transistors is greater than five times the threshold voltage of each transistor.

13. The method according to claim 11 or 12, further comprising shorting the gate to source voltage of each cascode transistor to drive each cascode transistor off when the the first control voltage is applied to the first gate electrode.

14. Use of the high voltage supply circuit of any of the claims 1 to 9 to drive heaters in a PCR reactor.

15. Use of the high voltage supply circuit of claim 10 in an inkjet print head.
